# EUROPÄISCHE PATENTANMELDUNG

(11) **EP 3 422 403 A1**
(43) Veröffentlichungstag der Anmeldung: **02.01.2019**
(21) Anmeldenummer: 17178977.9
(22) Anmeldetag: 30.06.2017
(51) Int. Cl.: H01L 23/427

(54) **KÜHLVORRICHTUNG**

(71) Anmelder: Siemens Aktiengesellschaft, 80333 München (DE)
(72) Erfinder: Ochs, Ewgenij, 90765 Fürth (DE); Pfefferlein, Stefan, 90562 Heroldsberg (DE)

(57) **Zusammenfassung**

Die Erfindung betrifft eine Kühlvorrichtung (1) zur Entwärmung mindestens eines elektronischen Bauelements (14,19), umfassend einen Kühlkörper (2) mit einer ersten und einer zweiten Kühlrippe (3,4) und ein erstes Wärmerohr (5), wobei zwischen der ersten und der zweiten Kühlrippe (3,4) eine erste Nut (6) am Kühlkörper (2) ausgebildet ist und das erste Wärmerohr (5) in der ersten Nut (6) angeordnet ist.

## Beschreibung

Die Erfindung betrifft eine Kühlvorrichtung zur Entwärmung mindestens eines elektronischen Bauelements und ein Herstellungsverfahren für die Kühlvorrichtung.

Eine effiziente Kühlung von elektronischen bzw. elektrotechnischen Bauelementen ist insbesondere für deren Einsatz in industrieellen Geräten und Systemen, wie beispielsweise in elektrischen Umrichtern eines Antriebssystems, eine wichtige Voraussetzung zur Erlangung einer erforderlichen Verfügbarkeit bei hoher Betriebssicherheit.

Herkömmliche, meist metallische Kühlkörper mit zumindest einseitig ausgeprägten Kühlrippen können oftmals die technischen und baulichen Kühlanforderungen für beispielsweise elektronische Bauelemente hoher elektrischer Leistungen nur begrenzt erfüllen. Um die am elektronischen Bauelement entstehende Wärmeenergie dennoch zu jedem Betriebszeitpunkt schnell und sicher abzuleiten, werden einerseits die Kühlkörper in ihren Abmaßen entsprechend groß dimensioniert oder es ist bekannt, einen Kühlkörper in Kombination mit Wärmerohren einzusetzen.

Wärmerohre sind meist in Form eines geschlossenen metallischen Rohres ausgebildet, beispielsweise eines Kupferrohres, dessen inneres Volumen nach außen gekapselt ist. Das Wärmerohr ist mit einem Wärmetransportmedium, beispielsweise Wasser oder Ammoniak, gefüllt.

Im Betrieb nimmt das Wärmerohr von einer Wärmequelle, beispielsweise dem elektronischen Bauelement, Wärmeenergie auf, wobei das Wärmetransportmedium an der Stelle des Wärmeeintrages der Wärmequelle verdampft und dadurch lokal der Druck ansteigt. Es entsteht im Inneren des Wärmerohres ein Druckgefälle und der an der Stelle des Wärmeeintrages erzeugte Dampf weicht zu einer weiteren Stelle mit geringerer Temperatur aus, wobei die von der Wärmequelle erzeugte Wärmeenergie mitgeführt wird.

Hier kondensiert das Wärmetransportmedium, was aufgrund der entstehenden Kondensationswärme eine Erhöhung der Temperatur zur Folge hat. Die so transportierte Wärmeenergie wird an der weiteren Stelle als Wärmeaustrag über das Wärmerohr an eine Wärmesenke der Umgebung abgegeben.

Durch die Schwerkraft des Wärmerohres, welches als Thermosiphon ausgebildet ist, bzw. durch Kapillarkräfte des Wärmerohres, welches als Heatpipe ausgebildet ist, strömt das nach dem Kondensationsvorgang wieder flüssige Wärmetransportmedium zu der Stelle zurück, an der das Wärmerohr die Wärmeenergie als Wärmeeintrag aus der Wärmequelle aufgenommen hat. Der Wärmetransportvorgang kann von Neuem beginnen.

Mittels derartiger Wärmerohre ist es demnach möglich, Wärmeenergie zielgerichtet von der Wärmequelle abzuführen, an anderer Stelle der Wärmesenke zuzuführen und danach beispielsweise über die Kühlrippen des Kühlkörpers an die Umgebung abzuleiten.

Bekannte Anordnungen von Kühlkörpern mit Kühlrippen und Wärmerohren sind derart ausgebildet, dass die Wärmerohre in eine kühlrippenfreie, meist ebene Fläche des Kühlkörpers eingebracht werden. An dieser ebenen Fläche werden oft die beispielsweise zu entwärmenden elektronischen Bauelemente angeordnet bzw. sind die elektronischen Bauelemente mit der ebenen Fläche des Kühlkörpers mechanisch verbunden.

Diese Kombination aus Kühlkörper und Wärmerohr ist jedoch um einen Faktor 2 deutlich kostenintensiver als der Einsatz eines Kühlkörpers mit Kühlrippen aber ohne Wärmerohr. Ein wesentlicher Grund dafür ist der vergleichsweise aufwändige Herstellungsprozess.

In die für die Einbringung der Wärmerohre vorgesehene kühlrippenfreie Kühlfläche des Kühlkörpers werden im Allgemeinen durch einen Arbeitsgang Einfräßen Rillen erzeugt. Anschließend werden in einem nächsten Arbeitsgang die Wärmerohre mechanisch in die Rillen eingefügt. Die so bearbeitete Kühlfläche des Kühlkörpers wird abschließend in einem weiteren Arbeitsgang plangefräst, um erneut eine ebene Kühlfläche zu erhalten, an der das elektronische Bauelement für einen effizienten Wärmeübergang der Wärmeenergie auf den Kühlkörper thermisch angeordnet und mechanisch befestigt werden kann.

Die Kühlrippen des Kühlkörpers sind demnach der mit den Wärmerohren versetzten ebenen Kühlfläche des Kühlkörpers abgewandt. Die Wärmeenergie, welche von der Wärmequelle mittels der Wärmerohre zu der Wärmesenke am Kühlkörper überführt wird, kann ferner über die Kühlrippen des Kühlkörpers an ein Medium der Umgebung, beispielsweise an die Luft, abgeleitet werden.

Wo aus technischer Sicht möglich und aus betriebswirtschaftlicher Sicht notwendig, wird aufgrund der vergleichsweise aufwändigen und kostenintensiven Herstellung der bisher bekannten Kombination von Kühlkörpern mit Kühlrippen und Wärmerohren meist auf deren Einsatz verzichtet.

Um demnach eine ausreichende Kühlwirkung zu erzielen, wird auf entsprechend größer dimensionierte aber dennoch preiswertere Standardkühlkörper zurückgegriffen, was jedoch das Abmaß, also die Baugröße eines Gerätes oder Systems, beispielsweise von elektrischen Umrichtern im Antriebssystem, ungünstig beeinflussen kann.

Andere Lösungen, wie beispielsweise der verstärkte Einsatz von Mitteln zur Zwangskühlung in Form von elektrischen Lüftern oder Kühlsystemen mit umlaufender Flüssigkeitskühlung, sind in diesem Zusammenhang denkbar, aber oft auch nicht wirtschaftlicher, erhöhen unter Umständen die technische Komplexität des Gesamtsystems und beinhalten ggf. auch erhöhte Ausfallrisiken.

Der Erfindung liegt daher die Aufgabe zugrunde, eine Kühlvorrichtung für elektronische Bauelemente sowie ein Herstellungsverfahren für die Kühlvorrichtung bereitzustellen, was die Vorteile der Kombination eines Kühlkörpers mit Kühlrippen und einem Wärmerohr für eine effiziente Kühlung aufgreift und eine im Vergleich zum Stand der Technik wirtschaftlichere Lösung in Bezug auf Einsatz und Herstellung bietet.

Die Aufgabe wird durch eine Kühlvorrichtung mit den in Anspruch 1 angegebenen Merkmalen gelöst. Ferner wird die Aufgabe durch ein Herstellungsverfahren nach Anspruch 13 gelöst.

Der Erfindung liegt die Erkenntnis zugrunde, dass einerseits eine bekannte Kombinationen aus einem Kühlkörper mit Kühlrippen und in den Kühlkörper an einer kühlrippenfreien ebenen Fläche des Kühlkörpers eingebrachte Wärmerohre eine effiziente Entwärmung von beispielsweise elektronischen Bauelementen in elektrischen Umrichtern von Antriebsystemen ermöglichen kann. Andererseits stellt sich jedoch eine derartige Lösung bzgl. Einsatz und Herstellung meist aus betriebswirtschaftlicher Sicht, also kostenbedingt, oft ungünstig dar.

Eine Veränderung des Aufbaus der bekannten Kühlvorrichtung, welche bei zumindest annähernd gleichen Kühleigenschaften im Vergleich zur bekannten Lösung im Ergebnis des veränderten Aufbaus jedoch unter anderem vergleichsweise aufwandsarm herstellbar ist, kann den Einsatz dieser neuen Kühlvorrichtung wirtschaftlicher, also kostengünstiger gestalten.

Für die Lösung der Aufgabe wird eine Kühlvorrichtung zur Entwärmung eines elektronischen Bauelements vorgeschlagen, umfassend einen Kühlkörper mit einer ersten und einer zweiten Kühlrippe und ein erstes Wärmerohr, wobei zwischen der ersten und der zweiten Kühlrippe eine erste Nut am Kühlkörper ausgebildet ist und das erste Wärmerohr in der ersten Nut angeordnet ist.

Der Kühlkörper ist für den Betrieb der Kühlvorrichtung mit mindestens einem ersten elektronischen Bauelement verbindbar, wobei im Betrieb der Kühlvorrichtung das erste elektronische Bauelement eine erste Verlustwärme erzeugt. Diese erste Verlustwärme wird zumindest teilweise als ein erster Wärmeeintrag in den Kühlkörper abgeleitet, wobei mittels des ersten Wärmeeintrages der ersten Verlustwärme im Kühlkörper unmittelbar zwischen dem ersten elektronischen Bauelement und zumindest einem jeweils ersten Teilbereich der ersten und zweiten Kühlrippe des Kühlkörpers eine erste Wärmequelle ausbildet wird.

Die erste Verlustwärme der ersten Wärmequelle im Kühlkörper wird u.a. direkt an ein Umgebungsmedium, beispielsweise Luft, abgeleitet. Ein im Allgemeinen größerer Teil der ersten Verlustwärme der ersten Wärmequelle wird von dem in der ersten Nut am Kühlkörper angeordneten ersten Wärmerohr und einem im ersten Wärmerohr gekapselten, teils flüssigen, teils gasförmigen ersten Wärmetransportmedium aufgenommen.

Nach bekannten Wärmerohr-Funktionsprinzipien wird im Betrieb der Kühlvorrichtung mittels des ersten Wärmetransportmediums des ersten Wärmerohres die von der ersten Wärmequelle des Kühlkörpers aufgenommene erste Verlustwärme abgeleitet und vom ersten Wärmerohr an eine von der ersten Wärmequelle entfernte erste Wärmesenke des Kühlkörpers abgegeben. Die weitere Ableitung der ersten Verlustwärme von der ersten Wärmesenke an das Umgebungsmedium kann über das Gesamtvolumen des Kühlkörpers, insbesondere auch über einen der ersten Wärmesenke gegenüberliegenden jeweiligen weiteren Teilbereich der ersten und der zweiten Kühlrippe des Kühlkörpers, erfolgen.

Die erste und die zweite Kühlrippe können einteilig oder auch mehrteilig ausgeführt sein. Die mehrteilige Ausführung der ersten und zweiten Kühlrippe ist beispielsweise als mehrteilige Stiftform (Pin-Fin) ausbildbar.

Für die effiziente Entwärmung des ersten elektronischen Bauelements mittels der Kombination von Kühlkörper und erstem Wärmerohr wird demnach die Anordnung des ersten Wärmerohres zwischen der ersten und der zweiten Kühlrippe des Kühlkörpers in vorteilhafter Weise genutzt.

Vorteilhafte Ausgestaltungsformen des Energieversorgungssystems sind in den abhängigen Ansprüchen angegeben.

Bei einer ersten vorteilhaften Ausgestaltungsform der erfindungsgemäßen Kühlvorrichtung ist das erste Wärmerohr am ersten Nutgrund der ersten Nut angeordnet, insbesondere am ersten Nutgrund mit dem Kühlkörper mechanisch befestigt.

Der erste Nutgrund der ersten Nut wird durch den Kühlkörper ausgebildet. Der erste Nutgrund verschließt die erste Nut in Richtung des Kühlkörpers.

Durch die Anordnung und insbesondere die Befestigung des ersten Wärmerohres am ersten Nutgrund der ersten Nut kann das erste Wärmerohr im Betrieb der Kühlvorrichtung die erste Verlustwärme von der ersten Wärmequelle des Kühlkörpers besonders vorteilhaft aufnehmen und im Weiteren mittels des ersten Wärmetransportmediums zu der von der ersten Wärmequelle entfernten ersten Wärmesenke des Kühlkörpers ableiten.

Bei einer weiteren vorteilhaften Ausgestaltungsform der erfindungsgemäßen Kühlvorrichtung erfolgt die mechanische Befestigung des ersten Wärmerohres mit dem Kühlkörper mittels mechanischer Deformation des ersten Wärmerohres am ersten Nutgrund der ersten Nut.

Die mechanische Deformierung des ersten Wärmerohres am ersten Nutgrund bewirkt eine kraftschlüssig mechanische Befestigung des ersten Wärmerohres mit dem Kühlkörper und mit der ersten und zweiten Kühlrippe, zumindest mit dem jeweiligen Übergang zwischen Kühlkörper und erster und zweiter Kühlrippe.

Die kraftschlüssig mechanische Befestigung vermindert oder verhindert beispielsweise das Fortbestehen bzw. die Bildung von Hohlräumen zwischen dem ersten Wärmerohr und dem Kühlkörper bzw. der ersten und der zweiten Kühlrippe, was den thermischen Übergang der ersten Verlustwärme von der ersten Wärmequelle im Kühlkörper zum ersten Wärmerohr im Gegensatz zu einer Lösung einer mechanischen Befestigung mittels ausschließlich einer Klebeverbindung oder einer nur formschlüssigen Verbindung verbessert.

Bei einer weiteren vorteilhaften Ausgestaltungsform der erfindungsgemäßen Kühlvorrichtung ist das quer zur ersten Nut verlaufende Profil des ersten Nutgrundes als ein radiales Profil oder als ein zumindest teilweise planes Profil ausgebildet.

Das radiale Profil des ersten Nutgrundes wird durch einen Teilkreis gebildet, welcher durch einen Radius bestimmt wird oder durch eine Teilellipse, aufweisend mehrere Teilkreise, gebildet, welche durch mehrere Radien bestimmt werden. Das zumindest teilweise plane Profil wird durch mindestens eine Gerade im Profil gebildet. Dabei kann das zumindest teilweise plane Profil auch eine oder mehrere Abrundungen, also einen oder mehrere Teilkreise und/oder eine oder mehrere Teilellipsen aufweisen.

Mittels des radialen Profils des ersten Nutgrundes passt sich das erste Wärmerohr mit einem im Wesentlichen runden Rohr-Querschnitt bei der mechanischen Deformation dem ersten Nutgrund mit vorteilhaft geringerem Kraftaufwand an, als das erste Wärmerohr, welches einen im Wesentlichen rechteckigen Rohr-Querschnitt aufweist. Entsprechend gegenteilig passt sich mittels des zumindest teilweisen planen Profils des ersten Nutgrundes das erste Wärmerohr mit einem im Wesentlichen rechteckigen Rohr-Querschnitt bei der mechanischen Deformation dem ersten Nutgrund mit vorteilhaft geringerem Kraftaufwand an, als das erste Wärmerohr, welches einen im Wesentlichen runden Rohr-Querschnitt aufweist.

Geringerer Kraftaufwand bei der Herstellung der kraftschlüssig mechanischen Befestigung des ersten Wärmerohres verringert demnach vorteilhaft auch die Gefahr der Zerstörung des ersten Wärmerohres oder des Kühlkörpers, insbesondere der ersten und der zweiten Kühlrippe des Kühlkörpers.

Bei einer weiteren vorteilhaften Ausgestaltungsform der erfindungsgemäßen Kühlvorrichtung weist das Profil des ersten Nutgrundes mindestens eine Ausbuchtung auf und/oder bildet der Übergang des Profils zur ersten und/oder zur zweiten Kühlrippe eine Hinterschneidung.

Die Ausbuchtung und die Hinterschneidung des Profils des ersten Nutgrundes sind von dem ersten Wärmerohr abgewandt und ragen in den Kühlkörper hinein. Die Ausbuchtung und/oder die Hinterschneidung sind insbesondere vorteilhaft als Arretierung für die mechanische Befestigung des ersten Wärmerohres ausgebildet.

Insbesondere die Ausbuchtung des Profils vergrößert die bei der mechanischen Befestigung mittels der mechanischen Deformation gebildeten und gemeinsam verbundenen Flächen vom Kühlkörper und dem erstem Wärmerohr, was den thermischen Übergang der ersten Verlustwärme von der ersten Wärmequelle des Kühlkörpers zu dem ersten Wärmerohr vorteilhaft verbessert.

Bei einer weiteren vorteilhaften Ausgestaltungsform der erfindungsgemäßen Kühlvorrichtung weist das Profil des ersten Nutgrundes mindestens eine Einbuchtung auf.

Die Einbuchtung des Profils des ersten Nutgrundes ist dem ersten Wärmerohr zugewandt und ragt aus dem Kühlkörper heraus. Die Einbuchtung ist vorteilhaft als Arretierung für die mechanische Befestigung des ersten Wärmerohres ausgebildet.

Die Einbuchtung des Profils vergrößert die bei der mechanischen Befestigung mittels der mechanischen Deformation gebildeten und gemeinsam verbundenen Flächen vom Kühlkörper und dem erstem Wärmerohr, was den thermischen Übergang der ersten Verlustwärme von der ersten Wärmequelle des Kühlkörpers zu dem ersten Wärmerohr vorteilhaft verbessert.

Bei einer weiteren vorteilhaften Ausgestaltungsform der erfindungsgemäßen Kühlvorrichtung ist unmittelbar zwischen dem ersten Nutgrund und dem ersten Wärmerohr ein Füllmaterial angeordnet, welches Klebeeigenschaften und/oder die thermische Leitfähigkeit unterstützende Eigenschaften aufweist.

Das Füllmaterial soll in vorteilhafter Weise verhindern, dass sich bei der mechanischen Befestigung des Kühlkörpers mit dem ersten Wärmerohr beispielsweise Hohlräume bilden, welche die mechanische Befestigung schwächen und/oder die thermische Leitfähigkeit der mechanischen Befestigung verringern.

Bei einer weiteren vorteilhaften Ausgestaltungsform der erfindungsgemäßen Kühlvorrichtung weist die Kühlvorrichtung ein erstes elektronisches Bauelement auf, welches derart an dem Kühlkörper mechanisch befestigt ist, dass es dem zwischen der ersten und der zweiten Kühlrippe angeordneten ersten Wärmerohr gegenüberliegt.

Je näher das erste elektronische Bauelement als Erzeuger der ersten Verlustwärme über den Kühlkörper mit dem ersten Wärmerohr verbunden ist, desto qualitativ und quantitativ effizienter kann im Betrieb der Kühlvorrichtung die erste Verlustwärme mittels des ersten Wärmerohres von der ersten Wärmequelle des Kühlkörpers und somit von dem ersten elektronischen Bauelement abgeleitet werden.

Bei einer weiteren vorteilhaften Ausgestaltungsform der erfindungsgemäßen Kühlvorrichtung weist der Kühlkörper weitere Kühlrippen und hierüber gebildet mindestens eine weitere Nut auf und ist in der weiteren Nut ein weiteres Wärmerohr am weiteren Nutgrund angeordnet, insbesondere am weiteren Nutgrund mit dem Kühlkörper mechanisch befestigt.

Die Anordnung und die Befestigung des weiteren Wärmerohres mit dem Kühlkörper an einem weiteren Nutgrund und die Ausbildung des Profils des weiteren Nutgrundes können analog zur Anordnung und Befestigung des ersten Wärmerohres mit dem Kühlkörper und der Ausbildung des Profils am ersten Nutgrund erfolgen.

Bei einer weiteren vorteilhaften Ausgestaltungsform der erfindungsgemäßen Kühlvorrichtung weist die Kühlvorrichtung mindestens ein weiteres elektronisches Bauelement auf, welches derart an dem Kühlkörper mechanisch befestigt ist, dass es dem zwischen zwei benachbarten weiteren Kühlrippen angeordneten weiteren Wärmerohr gegenüberliegt.

Die mechanische Befestigung des weiteren elektronischen Bauelementes mit dem Kühlkörper kann analog zur mechanischen Befestigung des ersten elektronischen Bauelementes mit dem Kühlkörper erfolgen.

Die Anzahl der für die Kühlvorrichtung vorgesehenen weiteren Wärmerohre ist insbesondere abhängig von der Anzahl der zu entwärmenden elektronischen Bauelemente und von deren jeweils erzeugter Verlustwärme.

Bei einer weiteren vorteilhaften Ausgestaltungsform der erfindungsgemäßen Kühlvorrichtung weisen mindestens zwei mit dem Kühlkörper befestigte Wärmerohre im Bereich des Kühlkörpers zueinander einen unterschiedlichen Umfang auf.

Es ist somit in vorteilhafter Weise möglich, das über den Umfang bestimmte Volumen bzw. die über den Umfang bestimmte Größe des oder der Wärmerohre an die im Betrieb der Kühlvorrichtung jeweils von dem oder den zu entwärmenden elektronischen Bauelementen erzeugte Verlustwärme anzupassen.

Bei einer weiteren vorteilhaften Ausgestaltungsform der erfindungsgemäßen Kühlvorrichtung sind das erste Wärmerohr und, falls mindestens ein weiteres Wärmerohr vorhanden ist, das weitere Wärmerohr jeweils als Heatpipe ausgebildet oder sind das erste Wärmerohr und, falls mindestens ein weiteres Wärmerohr vorhanden ist, das weitere Wärmerohr jeweils als Thermosiphon ausgebildet oder sind das erste Wärmerohr als Heatpipe und, falls mindestens ein weiteres Wärmerohr vorhanden ist, das weitere Wärmerohr als Thermosiphon ausgebildet.

Der Vorteil des Wärmerohres, welches als Heatpipe ausgebildet ist, besteht gegenüber dem Thermosiphon darin, dass die Heatpipe mittels der im Heatpipe-Innenraum im Allgemeinen vorhandenen Kapillare - und des damit verbundenen Dochtprinzips - den Transport des Wärmetransportmediums in jeder Einbaulage, ob horizontal oder vertikal, durchführen kann. Beim Wärmerohr, welches als Thermosiphon ausgebildet ist, wird der Transport des Wärmetransportmediums durch die Schwerkraft bestimmt, daher ist der horizontale Betrieb des Thermosiphon eher ungeeignet.

Für die Lösung der Aufgabe wird ebenfalls ein Herstellungsverfahren für die erfindungsgemäße Kühlvorrichtung vorgeschlagen, wobei in einem ersten Schritt das erste Wärmerohr in der ersten Nut am Kühlkörper angeordnet wird und, falls mindestens ein weiteres Wärmerohr vorgesehen ist, das weitere Wärmerohr in der weiteren Nut am Kühlkörper angeordnet wird und wobei in einem zweiten Schritt das erste Wärmerohr und, falls das weitere Wärmerohr vorhanden ist, das weitere Wärmerohr mechanisch deformiert werden und mittels der mechanischen Deformation am Nutgrund der jeweiligen Nut mit dem Kühlkörper mechanisch befestigt werden.

Bei einer ersten vorteilhaften Ausgestaltungsform des erfindungsgemäßen Herstellungsverfahrens wird in einem ersten Vorschritt das radiale Profil oder das zumindest teilweise plane Profil in den ersten Nutgrund für das erste Wärmerohr eingearbeitet und wird, falls das mindestens eine weitere Wärmerohr vorgesehen ist, in dem ersten Vorschritt das radiale Profil oder das zumindest teilweise plane Profil in den weiteren Nutgrund für das weitere Wärmerohr eingearbeitet.

Der erste Vorschritt ermöglicht in vorteilhafter Weise eine Anpassung des Profils des ersten Nutgrundes oder, falls mindestens ein weiterer Nutgrund vorhanden ist, des weiteren Nutgrundes an das mit dem oder den Nutgründen mechanisch zu befestigende jeweilige Wärmerohr.

Bei einer weiteren vorteilhaften Ausgestaltungsform des erfindungsgemäßen Herstellungsverfahrens wird in einem zweiten Vorschritt das Füllmaterial am ersten Nutgrund für das erste Wärmerohr eingebracht und wird, falls das mindestens eine weitere Wärmerohr vorgesehen ist, in dem zweiten Vorschritt das Füllmaterial an dem weiteren Nutgrund für das weitere Wärmerohr eingebracht.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Darstellung einer erfindungsgemäßen Kühlvorrichtung mit einem ersten Wärmerohr in einer ersten Nut eines Kühlkörpers zur Entwärmung eines ersten elektronischen Bauelements,
- FIG 2: eine weitere schematische Darstellung eines Anwendungsbeispiels der Kühlvorrichtung nach FIG 1 mit weiteren Wärmerohren in weiteren Nuten des Kühlkörpers zur Entwärmung auch eines weiteren elektronischen Bauelements,
- FIG 3: eine erste schematische Darstellung ein Anwendungsbeispiel des Profils des ersten Nutgrundes und der Profile weiterer Nutgründe für die Kühlvorrichtung nach FIG 1 und FIG 2,
- FIG 4: eine zweite schematische Darstellung ein weiteres Anwendungsbeispiel des Profils des ersten Nutgrundes und weiterer Nutgründe für die Kühlvorrichtung nach FIG 1 und FIG 2,
- FIG 5: eine dritte schematische Darstellung ein weiteres Anwendungsbeispiel des Profils des ersten Nutgrundes und der Profile weiterer Nutgründe für die Kühlvorrichtung nach FIG 1 und FIG 2,
- FIG 6: eine vierte schematische Darstellung ein weiteres Anwendungsbeispiel des Profils des ersten Nutgrundes und der Profile weiterer Nutgründe für die Kühlvorrichtung nach FIG 1 und FIG 2,
- FIG 7: eine fünfte schematische Darstellung ein weiteres Anwendungsbeispiel des Profils des ersten Nutgrundes und der Profile weiterer Nutgründe für die Kühlvorrichtung nach FIG 1 und FIG 2,
- FIG 8: eine schematische Darstellung der Kühlvorrichtung nach FIG 2 mit einem Einpressmittel und
- FIG 9: ein Struktogramm mit Verfahrensschritten eines erfindungsgemäßen Herstellungsverfahrens zur Herstellung einer erfindungsgemäßen Kühlvorrichtung.

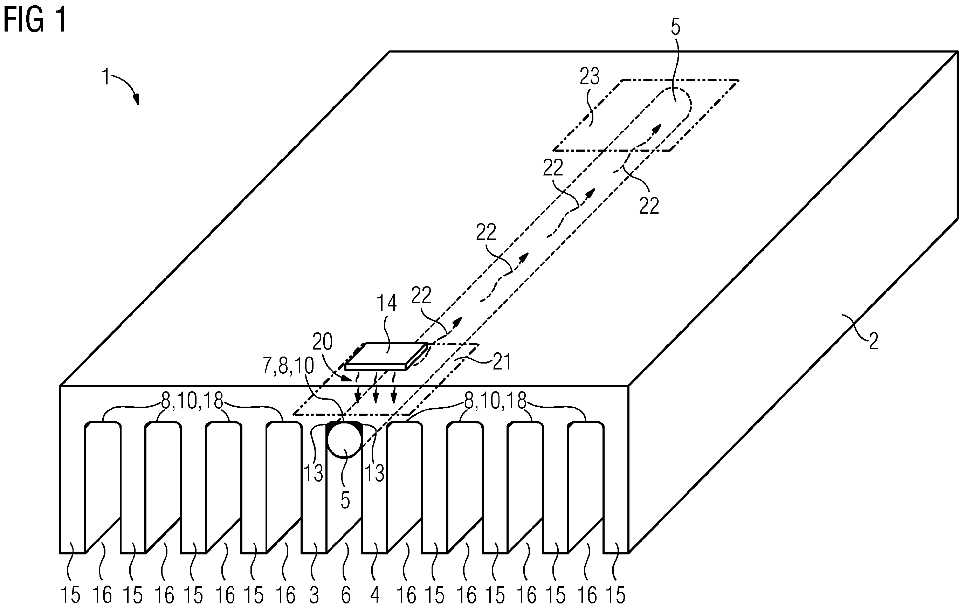

In FIG 1 wird eine schematische Darstellung einer erfindungsgemäßen Kühlvorrichtung 1 mit einem ersten Wärmerohr 5 in einer ersten Nut 6 eines Kühlkörpers 2 zur Entwärmung eines ersten elektronischen Bauelements 14 gezeigt.

Die erste Nut 6 wird durch die erste und die zweite Kühlrippe 3,4 gebildet und weist den ersten Nutgrund 7 auf. Der Kühlkörper 2 umfasst noch weitere Kühlrippen 15, welche weitere Nuten 16 bilden. Die weiteren Nuten 16 weisen jeweils einen weiteren Nutgrund 18 auf. Sowohl in den ersten Nutgrund 7 wie auch in die weiteren Nutgründe 18 ist als Profil 8 des jeweiligen Nutgrundes 7,18 ein zumindest teilweise planes Profil 10 eingearbeitet.

Das erste Wärmerohr 5 ist am ersten Nutgrund 7 der ersten Nut 6 mit dem Kühlkörper 2 mechanisch befestigt. Zwischen dem ersten Nutgrund 7 und dem ersten Wärmerohr 5 ist ein Füllmaterial 13 eingebracht. Acht weitere Nuten 16 des Kühlkörpers 2 weisen keine Wärmerohre auf.

Auf einer von den Kühlrippen 3,4,15 abgewandten Seite und planen Fläche des Kühlkörpers 2 ist ein erstes elektronisches Bauelement 14 mit dem Kühlkörper 2 mechanisch verbunden. Das erste elektronische Bauelement 14 ist dabei an einem Rand der planen Fläche des Kühlkörpers 2, aus Sicht des Betrachters der FIG 1 am vorderen Rand des Kühlkörpers 2, angeordnet.

Im Betrieb der Kühlvorrichtung 1 erzeugt das erste elektronische Bauelement 14 eine erste Verlustwärme 20. Diese erste Verlustwärme 20 wird zumindest teilweise als ein erster Wärmeeintrag in den Kühlkörper 2 abgeleitet, wobei mittels des ersten Wärmeeintrages der ersten Verlustwärme 20 im Kühlkörper 2 unmittelbar zwischen dem ersten elektronischen Bauelement 14 und zumindest einem jeweils ersten Teilbereich der ersten und zweiten Kühlrippe 3,4 des Kühlkörpers 2 eine erste Wärmequelle 21 ausbildet wird.

Die erste Verlustwärme 20 aus der ersten Wärmequelle 21 wird von dem in der ersten Nut 6 am Kühlkörper 2 angeordneten ersten Wärmerohr 5 und einem im ersten Wärmerohr 5 gekapselten, teils flüssigen, teils gasförmigen ersten Wärmetransportmedium 22 aufgenommen. Mittels des ersten Wärmetransportmediums 22 des ersten Wärmerohres 5 wird die von der ersten Wärmequelle 21 des Kühlkörpers 2 aufgenommene erste Verlustwärme 20 von dort abgeleitet und vom ersten Wärmerohr 5 an eine von der ersten Wärmequelle 21 entfernte erste Wärmesenke 23 des Kühlkörpers 2 abgegeben. Die weitere Ableitung der ersten Verlustwärme von der ersten Wärmesenke 23 an das Umgebungsmedium kann über das Gesamtvolumen des Kühlkörpers 2 (in FIG 1 nicht im Detail gezeigt), insbesondere auch über einen der ersten Wärmesenke 23 gegenüberliegenden jeweiligen weiteren Teilbereich der ersten und der zweiten Kühlrippe 3,4 des Kühlkörpers 2 erfolgen.

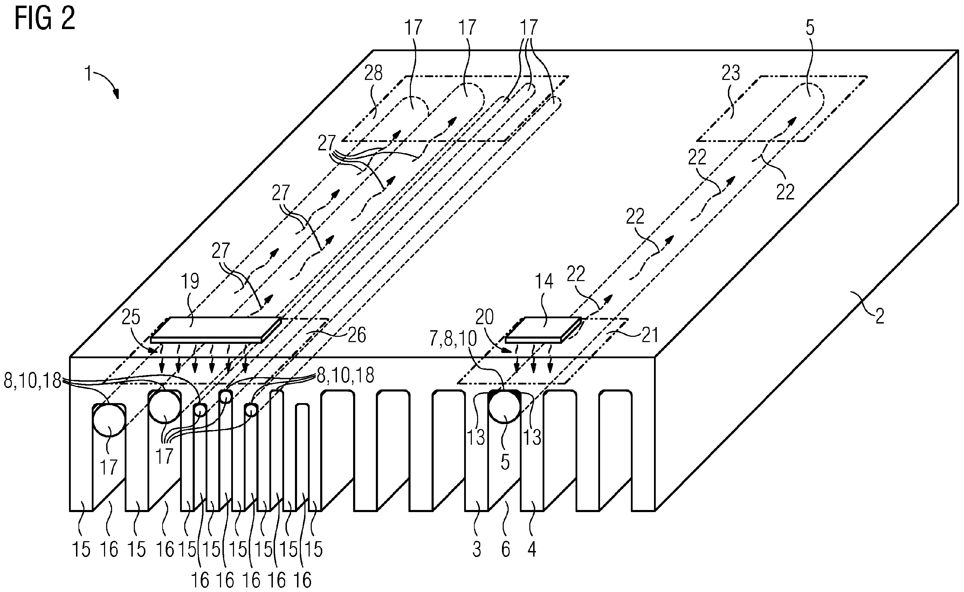

Mit FIG 2 wird eine weitere schematische Darstellung eines Anwendungsbeispiels der Kühlvorrichtung 1 nach FIG 1 mit weiteren Wärmerohren 17 in weiteren Nuten 16 des Kühlkörpers 2 zur Entwärmung eines weiteren elektronischen Bauelements 19. Dabei erweitert das Ausführungsbeispiel der Kühlvorrichtung 1 aus FIG 2 den schon in FIG 1 gezeigten und bereits beschriebenen Aufbau und die Funktionalität der dortigen Kühlvorrichtung 1.

Die in FIG 2 gezeigten weiteren Nuten 16 werden vergleichbar FIG 1 jeweils durch zwei sich gegenüberliegende weitere Kühlrippen 15 gebildet und weisen jeweils einen weiteren Nutgrund 18 auf. Alle weiteren Nutgründe 18 umfassen als Profil 8 ein zumindest teilweise planes Profil 10.

Dargestellt sind in FIG 2 fünf weitere Wärmerohre 17, wobei zwei der weiteren Wärmerohre 17 einen ersten Umfang und drei der weiteren Wärmerohre 17 einen zweiten Umfang aufweisen. Der erste und der zweite Umfang unterscheiden sich hinsichtlich der Größe. Die fünf weiteren Wärmerohre 17 sind jeweils an einem weiteren Nutgrund 18 einer weiteren Nut 16 mit dem Kühlkörper 2 mechanisch befestigt. Gezeigt werden noch sieben weitere Nuten 16 des Kühlkörpers 2, welche jedoch keine Wärmerohre aufweisen.

Auf der von den weiteren Kühlrippen 15 abgewandten Seite und planen Fläche des Kühlkörpers 2 ist ein weiteres elektronisches Bauelement 19 mit dem Kühlkörper 2 mechanisch verbunden. Das weitere elektronische Bauelement 19 ist baulich und elektrisch größer dimensioniert als das erste elektronische Bauelement 14. Demnach werden für den Betrieb der Kühlvorrichtung 1 auch fünf weitere Wärmerohre 17 für die Entwärmung des weiteren elektronischen Bauelementes 19 benötigt. Im Gegensatz dazu ist für die Entwärmung des ersten elektronischen Bauelementes 14 das eine erste Wärmerohr 5 ausreichend. Das weitere elektronische Bauelemente 19 ist vergleichbar mit dem ersten elektronischen Bauelement 14 ebenfalls am Rand der planen Fläche des Kühlkörpers 2, aus Sicht des Betrachters der FIG 2 am vorderen Rand des Kühlkörpers 2, angeordnet.

Im Betrieb der Kühlvorrichtung 1 erzeugt das weitere elektronische Bauelement 19 eine weitere Verlustwärme 25. Diese weitere Verlustwärme 25 wird zumindest teilweise als ein weiterer Wärmeeintrag in den Kühlkörper 2 abgeleitet, wobei mittels des weiteren Wärmeeintrages der weiteren Verlustwärme 25 im Kühlkörper 2 unmittelbar zwischen dem weiteren elektronischen Bauelement 19 und zumindest einem jeweils ersten Teilbereich weiterer Kühlrippen 15 des Kühlkörpers 2 eine weitere Wärmequelle 26 ausbildet wird.

Die weitere Verlustwärme 25 aus der weiteren Wärmequelle 26 wird von den jeweils in weiteren Nuten 16 am Kühlkörper 2 angeordneten weiteren Wärmerohren 17 und einem jeweils in den weiteren Wärmerohren 17 gekapselten, teils flüssigen, teils gasförmigen weiteren Wärmetransportmedium 27 aufgenommen. Mittels des jeweils weiteren Wärmetransportmediums 27 der weiteren Wärmerohre 17 wird die von der weiteren Wärmequelle 26 des Kühlkörpers 2 aufgenommene weitere Verlustwärme 25 von dort abgeleitet und von den weiteren Wärmerohren 17 an eine von der weiteren Wärmequelle 26 entfernte weitere Wärmesenke 28 des Kühlkörpers 2 abgegeben. Die weitere Ableitung der weiteren Verlustwärme von der weiteren Wärmesenke 28 an das Umgebungsmedium kann über das Gesamtvolumen des Kühlkörpers 2 (in FIG 2 nicht im Detail gezeigt), insbesondere auch über einen der weiteren Wärmesenke 23 gegenüberliegenden jeweiligen weiteren Teilbereich der weiteren Kühlrippen 15 des Kühlkörpers 2 erfolgen.

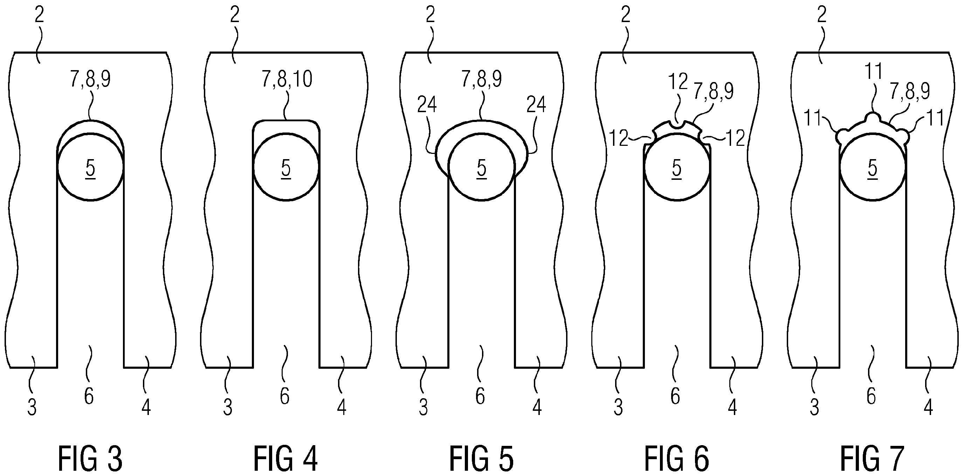

Die FIG 3 zeigt in einer ersten schematischen Darstellung ein Anwendungsbeispiel des Profils 8 des ersten Nutgrundes 7 und der Profile 8 der weiteren Nutgründe 18 für die Kühlvorrichtung nach FIG 1 und FIG 2.

Die Anordnung des Ausführungsbeispiels ist exemplarisch nur für den ersten Nutgrund 6 dargestellt, kann aber auch für die weiteren Nutgründe 18 gelten. Zu sehen ist in FIG 3 das erste Wärmerohr 5, welches am ersten Nutgrund 7 der ersten Nut 6 zwischen der ersten und der zweiten Kühlrippe 3,4 des Kühlkörpers 2 angeordnet ist.

Das erste Wärmerohr 5 ist in FIG 3 noch nicht vollständig mechanisch am ersten Nutgrund 7 befestigt. Der erste Nutgrund 7 weist als Profil 8 ein radiales Profil 9 auf.

Die FIG 4 zeigt in einer zweiten schematischen Darstellung ein Anwendungsbeispiel des Profils 8 des ersten Nutgrundes 7 und der Profile 8 der weiteren Nutgründe 18 für die Kühlvorrichtung nach FIG 1 und FIG 2.

Die Anordnung des Ausführungsbeispiels ist exemplarisch nur für den ersten Nutgrund 6 dargestellt, kann aber auch für die weiteren Nutgründe 18 gelten. Zu sehen ist in FIG 4 das erste Wärmerohr 5, welches am ersten Nutgrund 7 der ersten Nut 6 zwischen der ersten und der zweiten Kühlrippe 3,4 des Kühlkörpers 2 angeordnet ist.

Das erste Wärmerohr 5 ist in FIG 4 noch nicht vollständig mechanisch am ersten Nutgrund 7 befestigt. Der erste Nutgrund 7 weist als Profil 8 ein zumindest teilweise planes Profil 10 auf.

Die FIG 5 zeigt in einer dritten schematischen Darstellung ein Anwendungsbeispiel des Profils 8 des ersten Nutgrundes 7 und der Profile 8 der weiteren Nutgründe 18 für die Kühlvorrichtung nach FIG 1 und FIG 2.

Die Anordnung des Ausführungsbeispiels ist exemplarisch nur für den ersten Nutgrund 6 dargestellt, kann aber auch für die weiteren Nutgründe 18 gelten. Zu sehen ist in FIG 5 das erste Wärmerohr 5, welches am ersten Nutgrund 7 der ersten Nut 6 zwischen der ersten und der zweiten Kühlrippe 3,4 des Kühlkörpers 2 angeordnet ist.

Das erste Wärmerohr 5 ist in FIG 5 noch nicht vollständig mechanisch am ersten Nutgrund 7 befestigt. Der erste Nutgrund 7 weist als Profil 8 ein radiales Profil 9 auf. Dieses radiale Profil 9 umfasst zwei Hinterschneidungen 24, welche jeweils am Übergang des radialen Profils 9 vom ersten Nutgrund zur ersten und zweiten Kühlrippe 3,4 eingebracht sind.

Die FIG 6 zeigt in einer vierten schematischen Darstellung ein Anwendungsbeispiel des Profils 8 des ersten Nutgrundes 7 und der Profile 8 der weiteren Nutgründe 18 für die Kühlvorrichtung nach FIG 1 und FIG 2.

Die Anordnung des Ausführungsbeispiels ist exemplarisch nur für den ersten Nutgrund 6 dargestellt, kann aber auch für die weiteren Nutgründe 18 gelten. Zu sehen ist in FIG 6 das erste Wärmerohr 5, welches am ersten Nutgrund 7 der ersten Nut 6 zwischen der ersten und der zweiten Kühlrippe 3,4 des Kühlkörpers 2 angeordnet ist.

Das erste Wärmerohr 5 ist in FIG 6 noch nicht vollständig mechanisch am ersten Nutgrund 7 befestigt. Der erste Nutgrund 7 weist als Profil 8 ein radiales Profil 9 auf. Dieses radiale Profil 9 umfasst drei Einbuchtungen 12, welche dem ersten Wärmerohr 5 zugewandt sind und aus dem Kühlkörper 2 herausragen.

Die FIG 7 zeigt in einer fünften schematischen Darstellung ein Anwendungsbeispiel des Profils 8 des ersten Nutgrundes 7 und der Profile 8 der weiteren Nutgründe 18 für die Kühlvorrichtung nach FIG 1 und FIG 2.

Die Anordnung des Ausführungsbeispiels ist exemplarisch nur für den ersten Nutgrund 6 dargestellt, kann aber auch für die weiteren Nutgründe 18 gelten. Zu sehen ist in FIG 7 das erste Wärmerohr 5, welches am ersten Nutgrund 7 der ersten Nut 6 zwischen der ersten und der zweiten Kühlrippe 3,4 des Kühlkörpers 2 angeordnet ist.

Das erste Wärmerohr 5 ist in FIG 7 noch nicht vollständig mechanisch am ersten Nutgrund 7 befestigt. Der erste Nutgrund 7 weist als Profil 8 ein radiales Profil 9 auf. Dieses radiale Profil 9 umfasst drei Ausbuchtungen 11, welche dem ersten Wärmerohr 5 abgewandt sind und in den Kühlkörper 2 hineinragen.

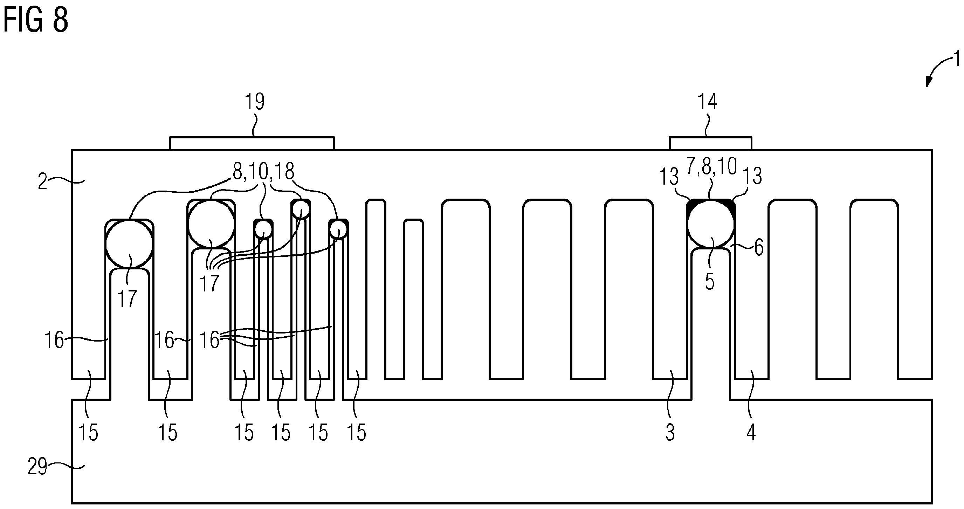

Eine schematische Darstellung der Kühlvorrichtung 1 nach FIG 2 mit einem Einpressmittel 29 zeigt die FIG 8. Mittels des Einpressmittels 29 können die im Betrieb der Kühlvorrichtung 1 für die Entwärmung der beiden elektronischen Bauelemente 14,19 vorgesehenen Wärmerohre 5,17 mit dem Kühlkörper 2 an den jeweiligen Nutgründen 7,18 der jeweiligen Nuten 6,16 durch mechanische Deformation mechanisch befestigt werden.

Dazu weist das Einpressmittel 29 stempelartige Ausbuchtungen auf, welche in einem meist einzigen Arbeitsgang in die jeweiligen Nuten 6,16 mit den dort angeordneten Wärmerohren 5,17 eingeführt werden und die Wärmerohre 5,17 mittels pressender Krafteinwirkung mechanisch deformieren und somit mechanisch am jeweiligen Nutgrund 7, 18 befestigen.

Die weiteren Wärmerohre 17 weisen teilweise unterschiedliche Umfänge auf, da die Abstände von weiteren, sich gegenüberliegenden Kühlrippen 15, welche die weiteren Nuten 16 bilden, ebenfalls teilweise unterschiedlich sind. Dies hat zur Folge, dass auch die Dimensionierungen der Ausbuchtungen des Einpressmittels 29 an die unterschiedlichen Abstände der weiteren, sich gegenüberliegenden Kühlrippen 15 angepasst sind.

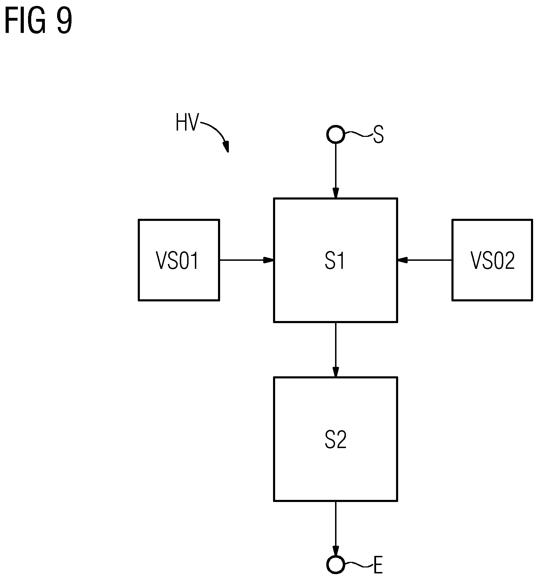

Mit FIG 9 wird ein Struktogramm mit Verfahrensschritten eines erfindungsgemäßen Herstellungsverfahrens HV zur Herstellung einer erfindungsgemäßen Kühlvorrichtung 1 nach FIG 1 oder FIG 2 aufgezeigt.

Nach dem Start S des Herstellungsverfahrens HV kann in einem ersten Vorschritt VS01 zum ersten Schritt S1 das radiale Profil oder das zumindest teilweise plane Profil in den ersten Nutgrund für das erste Wärmerohr eingearbeitet werden. Falls mindestens ein weiteres Wärmerohr vorgesehen ist, kann in dem ersten Vorschritt VS01 das radiale Profil oder das zumindest teilweise plane Profil auch in den weiteren Nutgrund für das weitere Wärmerohr eingearbeitet werden. Die notwendigen Bearbeitungen des oder der Profile des Nutgrundes für das oder die Wärmerohre richten sich insbesondere nach der Anzahl der zu verwendenden Wärmerohre und somit nach der Anzahl der zu entwärmenden elektronischen Bauelemente sowie nach der von den elektronischen Bauelementen jeweils erzeugten Verlustwärme. In das Profil des jeweiligen Nutgrundes können in dem ersten Vorschritt VS01 auch Hinterschneidungen, Ausbuchtungen bzw. Einbuchtungen eingearbeitet werden.

Ebenfalls nach dem Start S des Herstellungsverfahrens HV kann in einem zweiten Vorschritt VS02 zum ersten Schritt S1 das Füllmaterial am ersten Nutgrund für das erste Wärmerohr eingebracht werden. Falls mindestens ein weiteres Wärmerohr vorgesehen ist, kann in dem zweiten Vorschritt VS02 das Füllmaterial auch an dem weiteren Nutgrund für das weitere Wärmerohr eingebracht werden.

Im ersten Schritt S1 des Herstellungsverfahrens HV wird nach dem Start S das erste Wärmerohr in der ersten Nut am Kühlkörper angeordnet und, falls das mindestens eine weitere Wärmerohr vorgesehen ist, das weitere Wärmerohr in der weiteren Nut am Kühlkörper angeordnet.

In einem zweiten Schritt S2 des Herstellungsverfahrens HV wird das erste Wärmerohr und, falls das mindestens eine weitere Wärmerohr vorhanden ist, das weitere Wärmerohr mechanisch deformiert und mittels der mechanischen Deformation am Nutgrund der jeweiligen Nut mit dem Kühlkörper mechanisch befestigt.

Die mechanische Deformation des oder der Wärmerohre kann durch ein Einpressmittel erfolgen.

Mit dem Ende E ist das Herstellungsverfahren HV abgeschlossen.

## Patentansprüche

1. Kühlvorrichtung (1) zur Entwärmung mindestens eines elektronischen Bauelements (14,19), umfassend
- einen Kühlkörper (2) mit einer ersten und einer zweiten Kühlrippe (3,4) und
- ein erstes Wärmerohr (5),
wobei
- zwischen der ersten und der zweiten Kühlrippe (3,4) eine erste Nut (6) am Kühlkörper (2) ausgebildet ist und
- das erste Wärmerohr (5) in der ersten Nut (6) angeordnet ist.

2. Kühlvorrichtung (1) nach Anspruch 1, wobei das erste Wärmerohr (5) am ersten Nutgrund (7) der ersten Nut (6) angeordnet ist, insbesondere am ersten Nutgrund (7) mit dem Kühlkörper (2) mechanisch befestigt ist.

3. Kühlvorrichtung (1) nach Anspruch 2, wobei die mechanische Befestigung des ersten Wärmerohres (5) mit dem Kühlkörper (2) mittels mechanischer Deformation des ersten Wärmerohres (5) am ersten Nutgrund (7) der ersten Nut (6) erfolgt.

4. Kühlvorrichtung (1) nach einem der vorhergehenden Ansprüche, wobei das quer zur ersten Nut (7) verlaufende Profil (8) des ersten Nutgrundes (7) als ein radiales Profil (9) oder als ein zumindest teilweise planes Profil (10) ausgebildet ist.

5. Kühlvorrichtung (1) nach Anspruch 4, wobei das Profil (8) des ersten Nutgrundes (7) mindestens eine Ausbuchtung (11) aufweist und/oder der Übergang des Profils (8) zur ersten und/oder zur zweiten Kühlrippe (3,4) eine Hinterschneidung (24) bildet.

6. Kühlvorrichtung (1) nach Anspruch 4 oder 5, wobei das Profil (8) des ersten Nutgrundes (7) mindestens eine Einbuchtung (12) aufweist.

7. Kühlvorrichtung (1) nach einem der vorhergehenden Ansprüche, wobei unmittelbar zwischen dem ersten Nutgrund (7) und dem ersten Wärmerohr (5) ein Füllmaterial (13) angeordnet ist, welches Klebeeigenschaften und/oder die thermisch Leitfähigkeit unterstützende Eigenschaften aufweist.

8. Kühlvorrichtung (1) nach einem der vorhergehenden Ansprüche, aufweisend ein erstes elektronisches Bauelement (14), welches derart an dem Kühlkörper (2) mechanisch befestigt ist, dass es dem zwischen der ersten und der zweiten Kühlrippe (3,4) angeordneten ersten Wärmerohr (5) gegenüberliegt.

9. Kühlvorrichtung (1) nach einem der vorhergehenden Ansprüche, wobei
- der Kühlkörper (2) weitere Kühlrippen (15) und hierüber gebildet mindestens eine weitere Nut (16) aufweist und
- in der weiteren Nut (16) ein weiteres Wärmerohr (17) am weiteren Nutgrund (18) angeordnet ist, insbesondere am weiteren Nutgrund (18) mit dem Kühlkörper (2) mechanisch befestigt ist.

10. Kühlvorrichtung (1) nach Anspruch 9, aufweisend mindestens ein weiteres elektronisches Bauelement (19), welches derart an dem Kühlkörper (2) mechanisch befestigt ist, dass es dem zwischen zwei benachbarten weiteren Kühlrippen (15) angeordneten weiteren Wärmerohr (17) gegenüberliegt.

11. Kühlvorrichtung (1) nach Anspruch 9 oder 10, wobei mindestens zwei mit dem Kühlkörper (2) befestigte Wärmerohre (5,17) im Bereich des Kühlkörpers (2) zueinander einen unterschiedlichen Umfang aufweisen.

12. Kühlvorrichtung (1) nach einem der vorhergehenden Ansprüche, wobei
- das erste Wärmerohr (5) und, falls mindestens ein weiteres Wärmerohr (17) vorhanden ist, das weitere Wärmerohr (17) jeweils als Heatpipe ausgebildet sind oder
- das erste Wärmerohr (5) und, falls mindestens ein weiteres Wärmerohr (17) vorhanden ist, das weitere Wärmerohr (17) jeweils als Thermosiphon ausgebildet sind oder
- das erste Wärmerohr (5) als Heatpipe und, falls mindestens ein weiteres Wärmerohr (17) vorhanden ist, das weitere Wärmerohr (17) als Thermosiphon ausgebildet sind.

13. Herstellungsverfahren (HV) für eine Kühlvorrichtung (1) nach einem der Ansprüche 1 bis 12,
wobei
- in einem ersten Schritt (S1) das erste Wärmerohr (5) in der ersten Nut (6) am Kühlkörper (2) angeordnet wird und, falls mindestens ein weiteres Wärmerohr (17) vorgesehen ist, das weitere Wärmerohr (17) in der weiteren Nut (16) am Kühlkörper (2) angeordnet wird und
- in einem zweiten Schritt (S2) das erste Wärmerohr (5) und, falls das weitere Wärmerohr (17) vorhanden ist, das weitere Wärmerohr (17) mechanisch deformiert werden und mittels der mechanischen Deformation am Nutgrund (7,18) der jeweiligen Nut (6,16) mit dem Kühlkörper (2) mechanisch befestigt werden.

14. Herstellungsverfahren (HV) für eine Kühlvorrichtung (1) nach Anspruch 13, wobei in einem ersten Vorschritt (VS01) das radiale Profil (9) oder das zumindest teilweise plane Profil (10) in den ersten Nutgrund (7) für das erste Wärmerohr (5) eingearbeitet wird und wobei, falls das mindestens eine weitere Wärmerohr (17) vorgesehen ist, in dem ersten Vorschritt (VS01) das radiale Profil (9) oder das zumindest teilweise plane Profil (10) in den weiteren Nutgrund (18) für das weitere Wärmerohr (17) eingearbeitet wird.

15. Herstellungsverfahren (HV) für eine Kühlvorrichtung (1) nach Anspruch 13 oder 14, wobei in einem zweiten Vorschritt (VS02) das Füllmaterial (13) am ersten Nutgrund (7) für das erste Wärmerohr (5) eingebracht wird und wobei, falls das mindestens eine weitere Wärmerohr (17) vorgesehen ist, in dem zweiten Vorschritt (VS02) das Füllmaterial (13) an dem weiteren Nutgrund (18) für das weitere Wärmerohr (17) eingebracht wird.
